# EUROPEAN PATENT SPECIFICATION

(11) **EP 2 680 018 B1**
(45) Date of publication and mention of the grant of the patent: **23.10.2019**
(21) Application number: 10857736.2
(22) Date of filing: 01.12.2010
(51) Int. Cl.: G06F 3/023, G06F 3/041, H03K 17/96, H03M 11/00

(54) **METHOD AND APPARATUS FOR DETECTING KEY**
VERFAHREN UND VORRICHTUNG ZUR ERKENNUNG EINER TASTE
PROCÉDÉ ET APPAREIL DE DÉTECTION D'UNE CLÉ

(30) Priority: 30.09.2010 CN 201010515086
(43) Date of publication of application: 01.01.2014
(73) Proprietor: Jiangsu Huitong Group Co. Ltd., Zhenjiang, Jiangsu 212003 (CN)
(72) Inventor: LONG, Tao, Jiangsu 212003 (CN); LIU, Zhengdong, Jiangsu 212003 (CN); LONG, Jiang, Jiangsu 212003 (CN)
(74) Representative: Detken, Andreas
(86) International application number: PCT/CN2010/079309
(87) International publication number: WO 2012/040973

(56) References cited:
- WO-A1-96/18179
- CN-A- 101 079 637
- CN-A- 101 193 195
- JP-A- 5 175 820
- US-A1- 2006 227 115
- US-A1- 2008 297 205
- US-A1- 2010 096 193

## Description

### FIELD OF THE DISCLOSURE

The present disclosure generally relates to a key detection method and apparatus.

### BACKGROUND

At present, a variety of keys have been widely used in electronic products. The successful key detection rate may have a direct effect on electronic products. Key detection generally includes detecting an operation on a key and determining whether the key is pressed.

The existing key detection methods mainly include following steps: detecting a key to obtain a key signal; sampling the key signal with a fixed frequency; and outputting a control signal when the sampling times for an effective key signal in a predetermined time span reach or exceed a predetermined value.

In the existing methods, a false key triggering rate and a miss key detection rate increases and a successful key detection rate decreases if there is any interference of environment, such as noise from mobile phones or other electric appliances. US2008297205A1 discloses a switch system, where a controller generates an output signal based on a counter value signal received from a counter, and determines that a switch is in a first switch state when the counter value has exceeded a first state threshold and determines that the switch is in a second switch state when the counter value has declined below a second state threshold. US2006227115A1 discloses a touch sensitive control system which detects user manipulation of a touch sensitive interface with a touch detection sequence executed by the controller, where the touch detection sequence determines a moving average of baseline signal level readings of the touch sensitive interface over time, and compares a current baseline signal level reading to the moving average of baseline signal level readings to detect an interference event. WO9618179A1 discloses apparatus and method for capacitance-based touch detection, where a pair of electrode arrays establishes a capacitance on a touch detection pad which varies with movement of a conductive object near the pad, the capacitance variations are measured synchronously with a reference frequency signal to provide measure of position of the object, and electrical interference is rejected by producing a reference frequency signal which is not coherent with the interference.

### SUMMARY

The present disclosure provides a key detection method to increase the successful key detection rate.

This is achieved by the features of the key detection method defined in independent claim 1.

Optionally, the predetermined time span may be 3ms, the predetermined value may be 80, the first frequency may be 80KHz, the second frequency may be 120KHz, the predetermined time may be 5µs, and the 1 unit of frequency may be 1KHz.

Optionally, the key detection method further includes: receiving external signals; and when the frequency of an external signal is between the first frequency and the second frequency, generating a trigger signal which is used to trigger the key detection process.

Optionally, receiving external signals may include: receiving external signals at hopping frequencies, where receiving at hopping frequencies includes receiving external signals whose frequencies are equal to hopping frequency points, the hopping frequency increases from a third frequency to a fourth frequency, then decreases from the fourth frequency to the third frequency, and so the cycle to repeat, the frequency points in the increasing process are different from those in the decreasing process, and the third frequency is less than the first frequency and the fourth frequency is greater than the second frequency.

Optionally, the hopping frequency increases or decreases in 2 units of frequency.

Optionally, the frequency range from the third frequency to the fourth frequency may include three continuous frequency bands, namely, a first frequency band, a second frequency band and a third frequency band. The second frequency band may include a frequency band from the first frequency to the second frequency. Time stayed in each frequency point within the first frequency band or the third frequency band is less than that in each frequency point within the second frequency band.

Optionally, the third frequency may be 20KHz and the fourth frequency may be 500KHz.

Optionally, the frequency range from the third frequency to the fourth frequency may include three continuous frequency bands, namely, a first frequency band, a second frequency band and a third frequency band. The first frequency band is from 20KHz to 80KHz, the second frequency band is from 80KHz to 300KHz, and the third frequency band is from 300KHz to 500KHz. Time stayed in each frequency point within the first frequency band or in the third frequency band is 0.1ms and time stayed in each frequency point within the second frequency band is 0.2ms.

Optionally, the hopping frequency increasing from the third frequency to the fourth frequency may include: the hopping frequency increasing from 20KHz to 21KHz, then increasing from 21KHz to 499KHz in 2KHz and increasing from 499KHz to 500KHz. The hopping frequency decreasing from the fourth frequency to the third frequency may include: the hopping frequency decreasing from 500KHz to 20KHz in 2KHz.

The present disclosure further provides a key detection apparatus as defined in independent claim 7.

Optionally, the predetermined time span may be 3ms, the predetermined value may be 80, the first frequency may be 80KHz, the second frequency may be 120KHz, the predetermined time may be 5µs, and the 1 unit of frequency may be 1KHz.

Optionally, the key detection apparatus further includes: a receiving unit configured to receive external signals; and an external signal detecting unit configured to generate a trigger signal which is used to trigger the key detection process when the frequency of an external signal is between the first frequency and the second frequency. After receiving the trigger signal, the key detecting unit may detect a key to obtain a key signal.

Optionally, the receiving unit may include: an antenna configured to receive external environment signals; and a frequency hopping receiving unit configured to receiving external signals at hopping frequencies. Receiving at hopping frequencies includes receiving external signals whose frequencies are equal to hopping frequency points, the hopping frequency increases from a third frequency to a fourth frequency, then decreases from the fourth frequency to the third frequency, and so the cycle to repeat, the frequency points in the increasing process are different from those in the decreasing process, and the third frequency is less than the first frequency and the fourth frequency is greater than the second frequency.

Optionally, the hopping frequency increases or decreases in 2 units of frequency.

Optionally, the frequency range from the third frequency to the fourth frequency may include three continuous frequency bands, namely, a first frequency band, a second frequency band and a third frequency band. The second frequency band may include a frequency band from the first frequency to the second frequency. Time stayed in each frequency point within the first frequency band or the third frequency band is less than that in each frequency point within the second frequency band.

Optionally, the third frequency may be 20KHz and the fourth frequency may be 500KHz.

Optionally, the frequency range from the third frequency to the fourth frequency may include three continuous frequency bands, namely, a first frequency band, a second frequency band and a third frequency band. The first frequency band is from 20KHz to 80KHz, the second frequency band is from 80KHz to 300KHz, and the third frequency band is from 300KHz to 500KHz. Time stayed in each frequency point within the first frequency band or in the third frequency band is 0.1ms and time stayed in each frequency point within the second frequency band is 0.2ms.

Optionally, the hopping frequency increasing from the third frequency to the fourth frequency may include: the hopping frequency increasing from 20KHz to 21KHz, then increasing from 21KHz to 499KHz in 2KHz and increasing from 499KHz to 500KHz. The hopping frequency decreasing from the fourth frequency to the third frequency may include: the hopping frequency decreasing from 500KHz to 20KHz in 2KHz.

In the present disclosure, a key signal is sampled at varying frequencies and its effectiveness is determined. Compared with a fixed sampling frequency in the existing methods, varying sampling frequencies are difficult to be tracked by varying external signals, thereby reducing the probability of sampled signals being interfered by external signals.

Further, key detection may be initiated after an external signal with a frequency within a predetermined frequency range is received. External signals are received at hopping frequency points, which means that external signals with one kind of frequency point are received in a particular time span. Embodiments of the present disclosure combine receiving signals at hopping frequency points with sampling signals at varying frequencies, which further decreases the coincidence between sampling frequency and external signals' frequency, and thereby decreases interferences in key detection.

Further, external signals are received in a predetermined frequency range (from a first frequency to a second frequency) in forward hopping frequency, backward hopping frequency, and so the cycle to repeat, hopping frequency points in the forward process are different from those in the backward process, and staying time at each frequency point lasts for a predetermined time, which improve detection rate, and almost will not miss a key press event.

### BRIEF DESCRIPTION OF THE DRAWINGS

FIG. 1 schematically illustrates a flow chart of a key detection method according to one embodiment of the present disclosure;
FIG. 2 schematically illustrates a detailed flow chart of Step S12 shown in FIG. 1;
FIG. 3 schematically illustrates a flow chart of a key detection method according to another embodiment of the present disclosure;
FIG. 4 schematically illustrates a structure of a key detection apparatus according to one embodiment of the present disclosure;
FIG. 5 schematically illustrates a structure of a key detection apparatus according to another embodiment of the present disclosure;
FIG. 6 schematically illustrates a structure of an anti-interference capacitive touch-key detection system according to one embodiment of the present disclosure; and
FIG. 7 schematically illustrates a detailed structure of an anti-interference capacitive touch-key detection system according to one embodiment of the present disclosure.

### DETAILED DESCRIPTION OF THE DISCLOSURE

In the existing key detection technologies, a key signal is sampled with a fixed frequency and the sampling frequency is easy to be tracked by varied external environment signals, and the sampled signals are thereby interfered, resulting in missing effective key signals or an interference signal mistaken as an effective key signal. The present disclosure provides a method to sample a key signal with varying frequencies, thereby reducing risk of sampling signals being interfered by external signals.

In order to clarify the objects, characteristics and advantages of the disclosure, embodiments of present disclosure will be described in detail in conjunction with accompanying drawings. In following embodiments, a key may be a capacitive touch-key, which is not limited thereto. For example, it may be a resistive key or a switching key in other examples.

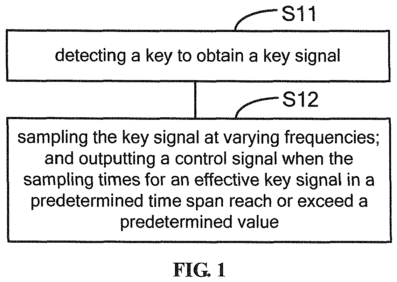

FIG. 1 schematically illustrates a flow chart of a key detection method according to one embodiment of the present disclosure, the key detection method including steps of:
Step S11, detecting a key to obtain a key signal; and
Step S12, sampling the key signal at varying frequencies and outputting a control signal when the sampling times for an effective key signal in a predetermined time span reach or exceed a predetermined value, where the sampling frequency varies from a first frequency increasing to a second frequency, then from the second frequency decreasing to the first frequency, the sampling staying in each frequency point for a predetermined time, and the increasing sampling and the decreasing sampling processes are repeated.

Hereinafter, Step S11 and Step S12 are described in detail.

In Step S11, a key may be detected and a key signal may be obtained. In some embodiments, the key may be a capacitive touch-key, such as an air key or a contact key. Generally, there is a parasitic capacitance to ground in a key. Once a key is pressed, the parasitic capacitance in the key is to be paralleled with a finger capacitance to ground. Therefore, whether a key is pressed can be determined by detecting the capacitance charge or the capacitance value.

In some embodiments, Step S11 may include: detecting a charge change amount in a capacitance (e.g. a parasitic capacitance) to obtain a key signal, where the key signal is a digital signal corresponding to the charge change amount in the capacitance and used to determine whether a key is pressed in subsequent steps. A digital signal corresponding to the charge change amount in the capacitance means numerical value which the digital signal represents may be the charge change amount in the capacitance or may be proportional to the charge change amount in the capacitance. The technology for detecting charge change amount in a capacitance is known to those skilled in the art and is not described in detail herein.

Following Step S11, Step S12 may be performed. In Step S12: sampling the key signal at varying frequencies and outputting a control signal when the sampling times for an effective key signal in a predetermined time span reach or exceed a predetermined value. Namely, whether the sampling times for an effective key signal in a predetermined time span reach or exceed a predetermined value is determined. If so, a control signal is output and the key may be predetermined to be pressed; otherwise, the key signal is determined to be caused by interference of external signals. Sampling at varying frequencies may include sampling from a first frequency increasing to a second frequency, then from the second frequency decreasing to the first frequency, repeating the increasing and decreasing sampling processes, and the sampling stay in each frequency point for a predetermined time.

Optionally, sampling an effective key signal may include: sampling a key signal; and determining a sampled key signal to be an effective one when numerical value of the sampled key signal is greater than a threshold of charge change amount.

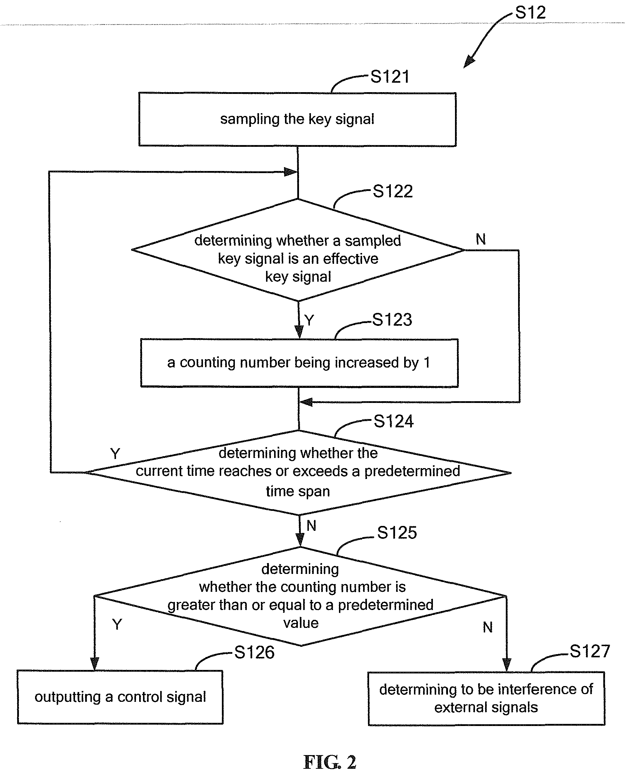

In some embodiments, FIG. 2 schematically illustrates a detailed flow chart of Step S12. Step S12 may include steps of:

Step S121, sampling the key signal, namely, sampling a digital signal corresponding to the charge change amount in a capacitance obtained in Step S11, where the sampling frequency increases from a first frequency to a second frequency and then decreases from the second frequency to the first frequency, this increasing and decreasing sampling process is performed repeatedly, and the sampling may stay in each frequency point for a predetermined time.

In some embodiments, the sampling frequency may vary between the first frequency and the second frequency (including the first frequency and the second frequency) in turn. An increment value (an increment value each time of the sampling frequency increasing from the first frequency to the second frequency) and a decrement value (an decrement value each time of the sampling frequency decreasing from the second frequency to the first frequency) of the sampling frequency is 1 unit of frequency, namely, the sampling frequency increases or decreases in an equal difference. Specifically, the sampling frequency increases from the first frequency to the second frequency in 1 unit of frequency (i.e. the unit of the first frequency and the second frequency, for example, if the unit is KHz, the sampling frequency increasing in 1KHz each time) and the sampling may stay in each frequency point for a predetermined time, namely, the sampling frequency increases in 1 unit of frequency every predetermined time; then the sampling frequency decreases from the second frequency to the first frequency in 1 unit of frequency and the sampling may stay in each frequency point for the predetermined time, namely, the sampling frequency decreases in 1 unit of frequency every predetermined time; furthermore, the sampling frequency increases from the first frequency to the second frequency and decreases from the second frequency to the first frequency, and the increasing sampling and the decreasing sampling is repeated.

The first frequency and the second frequency may respectively be a lower limit and an upper limit of frequency of signals generated after a key is pressed and they are always determined by an experience value according to practical application. For example, a capacitive touch-key is pressed by a finger. Signals between 80KHz and 120KHz may be generated accordingly. Therefore, the first frequency may be set to be 80KHz and the second frequency may be set to be 120KHz. The 1 unit of frequency may be 1KHz. The predetermined time may depend on a predetermined time span and a predetermined value of times (sometimes being experience value). Namely, according to the predetermined time, effective key signals may be sampled more than the predetermined value of times in the predetermined time span. For example, the predetermined time span is 3ms and the predetermined value is 80, then the predetermined time may be 5µs. The sampling frequency may be 80KHz at first, then increases to 81KHz 5µs later, increases to 82KHz after another 5µs, and so on, until the sampling frequency reaches 120KHz, and it takes 200µs to finish this increasing process; then, the sampling frequency decreases from 120KHz to 119KHz 5µs later, decreases to 118KHz after another 5µs, and so on, until the sampling frequency reaches 80KHz, and it takes 200µs to finish this decreasing process. Thus a cycle process including a increasing process and a decreasing process may be 400µs, and a key signal (digital signal) may be sampled 11 times therein. 3ms includes 7.5 cycles, therefore, a key signal may be sampled 82 to 83 times therein.

Step S122, determining whether a sampled key signal is an effective key signal, if so, proceeding to Step S123; otherwise, proceeding to Step S124. A key signal being an effective key signal means numerical value of the key signal is greater than a threshold of charge change amount.

Step S123, a counting number being increased by 1 and proceeding to Step S124. The original counting number is 0 and the counting number is used to count times for obtaining an effective key signal. The counting number may be increased by 1 when the sampled key signal is an effective key signal.

Step S124, determining whether the current time reaches or exceeds the predetermined time span, if so, proceeding to Step S125; otherwise, proceeding to Step S122. Each time after the sampled key signal is determined to be not an effective key signal, or the sampled key signal is determined to be an effective key signal and the counting number is increased by 1, the difference between the current time and the start time of Step S12 is determined whether to be greater than or equal to the predetermined time span, if so, proceeding to Step S125; otherwise, proceeding to Step S122.

Step S125, determining whether the counting number is more than or equal to the predetermined value, if so, proceeding to Step S126; otherwise, proceeding to

Step S127. If difference between the current time and the start time of Step S12 is greater than or equal to the predetermined time span, the counting number is determined whether to be greater than or equal to the predetermined value, if so, proceeding to Step S126; otherwise, proceeding to Step S127.

Step S126, outputting a control signal. If the counting number within the predetermined time span is greater than or equal to the predetermined value, a control signal is output, which means that the key is pressed or probable to be pressed.

Step S127, determining to be interference of external signals. If the counting number within the predetermined time span is less than the predetermined value, it means that the key is not pressed and the key detection may be interfered by external interference signals.

Generally, the abovementioned Step S121 may be performed in parallel with Step S122 to S125.

The control signal and / or the determination result of whether the sampling times for an effective key signal in a predetermined time span reach or exceed a predetermined value may be used to further determine operation on the key in subsequent process. For example, Step S11 and Sep S12 may be performed repeatedly in 3s. If control signals are generated all the time, it means the key is pressed continuously.

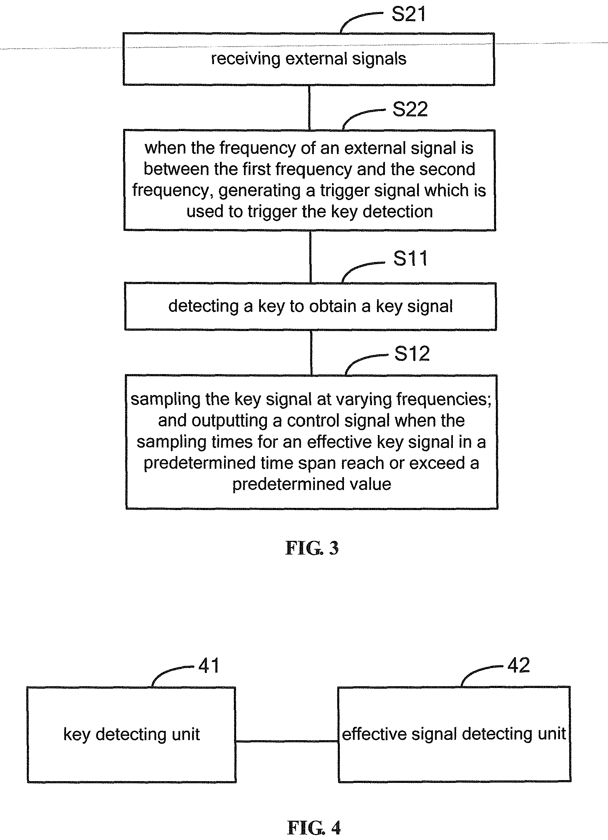

FIG. 3 schematically illustrates a flow chart of a key detection method according to another embodiment of the present disclosure. The difference between the embodiment and the first embodiment lies in: before Step S11, the method may further include: receiving external signals and generating a trigger signal to trigger the key detection process when the frequency of an external signal is between a first frequency and a second frequency, namely, after a trigger signal is generated, Step S11 is started.

The key detection method shown in FIG. 3 may include:
Step S21, receiving external signals;
Step S22, generating a trigger signal to trigger the key detection process when the frequency of an external signal is between the first frequency and the second frequency;

Thereafter, Step S11, detecting a key to obtain a key signal, namely, detecting a key after the trigger signal is generated; and

Step S12, sampling the key signal at varying frequencies and outputting a control signal when the sampling times for an effective key signal in a predetermined time span reach or exceed a predetermined value, where the sampling frequency varies from a first frequency increasing to a second frequency and then decreasing from the second frequency to the first frequency, the increasing and decreasing sampling processes are repeated, and the sampling may stay in each frequency point for a predetermined time.

The abovementioned Steps S11 and S12 are the same as in the first embodiment, so only Steps S21 and S22 are described in detail hereinafter.

First, Step S21 may be performed. In Step S21, external signals may be received. The external signals may include signals caused by environment signals and key operation from external, which may be received through an antenna. A frequency range of signals received by the antenna may depend on the antenna. In some embodiments, the frequency range of signals received by the antenna may be from 20KHz to 500KHz.

In some embodiments, receiving external signals may include: receiving external signals at hopping frequencies, where receiving at hopping frequencies includes receiving external signals whose frequencies are equal to hopping frequency points, the hopping frequency increases from a third frequency to a fourth frequency, then decreases from the fourth frequency to the third frequency, and so the cycle to repeat, the frequency points in the increasing process are different from those in the decreasing process, and the third frequency is less than the first frequency and the fourth frequency is greater than the second frequency. The third frequency is a lower limit of frequency of signals received by an antenna, for example, 20KHz; and the fourth frequency is an upper limit of frequency of signals received by the antenna, for example, 500KHz. In other embodiments, external signals may be received not at hopping frequencies, while the antenna keeps in reception state all the time.

In some embodiments, an increment value (an increment value each time of the hopping frequency increasing from the third frequency to the fourth frequency) and a decrement value (a decrement value each time of the hopping frequency decreasing from the fourth frequency to the third frequency) of the hopping frequency is 2 units of frequency, namely, the hopping frequency increases or decreases in an equal difference.

The hopping frequency progressively increasing from 20KHz to 500KHz may be frequencies with an almost equal difference, e.g., the hopping frequency increasing from 20KHz to 21KHz, then increasing from 21KHz to 499KHz in 2KHz and then increasing from 499KHz to 500KHz; the hopping frequency progressively decreasing from 500KHz to 20KHz may be frequencies with an equal difference, e.g., the hopping frequency decreasing from 500KHz to 20KHz in 2KHz. In some embodiments, the frequencies points in the increasing process and in the decreasing process are different, e.g., odd ones and even ones, respectively.

Optionally, the frequency range from the third frequency to the fourth frequency may include three continuous frequency bands, namely, a first frequency band, a second frequency band and a third frequency band. The second frequency band may include a frequency band from the first frequency to the second frequency. Time stayed in each frequency point within the first frequency band or the third frequency band is less than that in each frequency point within the second frequency band. For example, the third frequency is 20KHz and the fourth frequency is 500KHz. Accordingly, the first frequency band may be from 20KHz to 80KHz, the second frequency band may be from 80KHz to 300KHz, and the third frequency band may be from 300KHz to 500KHz. Time stayed in each frequency point within the first frequency band or in the third frequency band is 0.1ms and time stayed in each frequency point within the second frequency band is 0.2ms.

In some embodiments, time stayed at each frequency point within a first frequency band, a second frequency band and a third frequency band (a frequency band from a third frequency to a fourth frequency) may be the same. In some embodiments, external signals with frequencies within a first frequency band or a third frequency band are generally interference signals, shortening residence time at each frequency point within these two frequency bands (being less than that at each frequency point within a second frequency band) may increase frequency hopping rate, thus reduce detection time and improve a utilization rate of system resources.

Following Step S21, Step S22 may be performed. In Step S22, a trigger signal may be generated to trigger the key detection process when the frequency of an external signal is between the first frequency and the second frequency. The first frequency and the second frequency may respectively be a lower limit and an upper limit of frequency of signals which are caused by an operation on a key (e.g. pressing a key). In some embodiments, the first frequency is 80KHz and the second frequency is 120KHz. In the present disclosure, a subsequent key detection process is performed when an external signal with a frequency between the first frequency and the second frequency (including the first frequency and the second frequency) is received, namely, when a key is possible to be pressed. Specifically, whether the frequency of an external signal is between the first frequency and the second frequency or not is determined. If so, a trigger signal is generated; otherwise, the external signal is determined to be caused by interferences of environment.

Corresponding to the abovementioned key detection method, a key detection apparatus according to one embodiment of the present disclosure is illustrated in FIG. 4, including a key detecting unit 41 and an effective signal detecting unit 42.

The key detecting unit 41 is configured to detect a key to obtain a key signal. In some embodiments, the key may be a capacitive touch-key, the key detecting unit may be a capacitance detecting unit configured to detect a charge change amount in a capacitance. The key signal is a digital signal corresponding to the charge change amount in the capacitance. In some embodiments, the capacitance detecting unit may be implemented by an Analog to Digital Converter (ADC) which is configured to detect the charge change amount in the capacitance and convert analog data of charge change to digital data.

The effective signal detecting unit 42 is configured to sample the key signal at varying frequencies and output a control signal when the sampling times for an effective key signal in a predetermined time span reach or exceed a predetermined value, where the sampling frequency varies from a first frequency increasing to a second frequency, then from the second frequency decreasing to the first frequency, the increasing and decreasing sampling processes are repeated, and the sampling may stay in each frequency point for a predetermined time. The 1 unit of frequency may be 1KHz. A key signal being an effective key signal means numerical value of the key signal is greater than a threshold of charge change amount. In some embodiments, the effective signal detecting unit 42 may be implemented by a Micro Controller Unit (MCU).

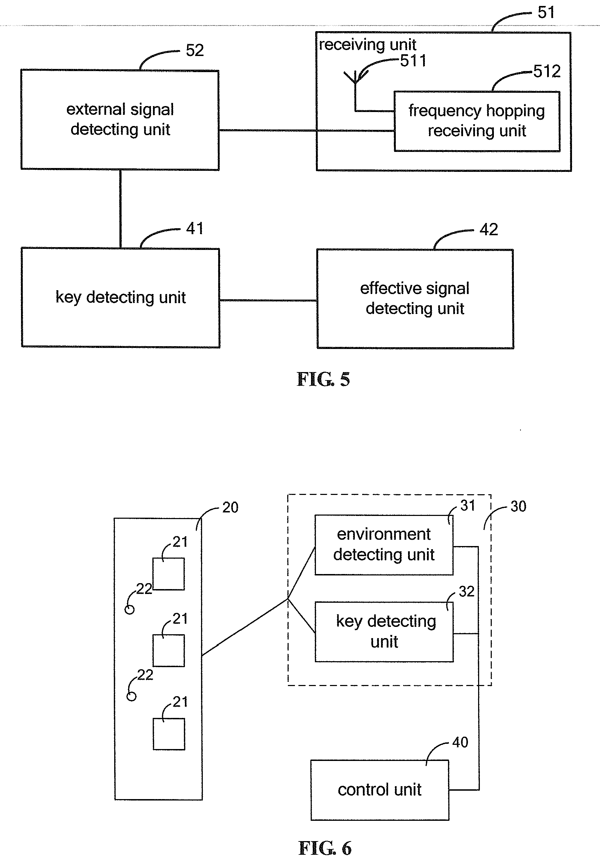

A key detection apparatus according to another embodiment of the present disclosure is illustrated in FIG. 5, including a receiving unit 51, an external signal detecting unit 52, a key detecting unit 41 and an effective signal detecting unit 42.

The receiving unit 51 is configured to receive external signals. In some embodiments, the receiving unit 51 may include an antenna 511 and a frequency hopping receiving unit 512. The antenna 511 is configured to receive external environment signals; and the frequency hopping receiving unit 512 is configured to receive external signals at hopping frequencies. Receiving at hopping frequencies includes receiving external signals whose frequencies are equal to hopping frequency points, and transmitting the received external environment signals to the external signal detecting unit 52, the hopping frequency increases from a third frequency to a fourth frequency, then decreases from the fourth frequency to the third frequency, and so the cycle to repeat, the frequency points in the increasing process are different from those in the decreasing process, and the third frequency is less than the first frequency and the fourth frequency is greater than the second frequency. In other embodiments, a receiving unit 51 may be used as an antenna, namely, the receiving unit 51 directly receives external environment signals and transmits the received external environment signals to an external signal detecting unit 52.

The hopping frequency increases or decreases in 2 units of frequency. The frequency range from the third frequency to the fourth frequency may include three continuous frequency bands, namely, a first frequency band, a second frequency band and a third frequency band. The second frequency band may include a frequency band from the first frequency to the second frequency. Time stayed in each frequency point within the first frequency band or the third frequency band is less than that in each frequency point within the second frequency band.

The external signal detecting unit 52 is configured to generate a trigger signal which is used to trigger the key detection process when the frequency of an external signal is between the first frequency and the second frequency. The external signal detecting unit 52 is connected to the key detecting unit 41 and transmits the trigger signal to it.

The key detecting unit 41 is configured to detect a key to obtain a key signal after receiving the trigger signal from the external signal detecting unit 52. The effective signal detecting unit 42 is the same as the first embodiment and is not described in detail therein.

The abovementioned key detection method may be applied in a key detection system, which may eliminate interference of ambient noises and increase accuracy of key detection. The key may be a contact key, such as a capacitive touch-key, or other types of keys, such as an air key. The contact key denotes the key where bodies may directly contact with metal plates and the air key denotes the key where bodies may not directly contact with metal plates.

FIG. 6 schematically illustrates a structure of an anti-interference capacitive touch-key detection system, including: capacitive touch-keys 21, an environment detecting unit 31, a key detecting unit 32 and a control unit 40. The environment detecting unit 31 is configured to detect background environment signals, shield signals with frequencies beyond the range from a first frequency to a second frequency and generate a trigger signal after a signal with a frequency between the first frequency and the second frequency is detected; the key detecting unit 32 is configured to detect a key, triggered by the trigger signal, to obtain a key signal; and the control unit 40 is configured to sample the key signal, triggered by the trigger signal, and output a control signal when the sampling times for an effective key signal in a first time window reach or exceed a predetermined value.

The capacitive touch-keys are set on a detection plate 20. The detection plate 20 may be a Printed Circuit Board (PCB). At least one balance point 22 is set on the detection plate 20. The balance point may be made of metal and used to adjust the frequency reception and response range of the detection plate 20, which is described in further detail below.

Furthermore, the environment detecting unit 31 and the key detecting unit 32 may be integrated on one detection chip 30. The key detecting unit 32 is configured to detect a charge change amount in the keys 21, namely, the difference between the current charge in the keys 21 and the charge therein under the original balanced state, and convert the charge change amount to corresponding digital signals which correspond to the charge change amount.

The control unit 40 may be implemented by a MCU.

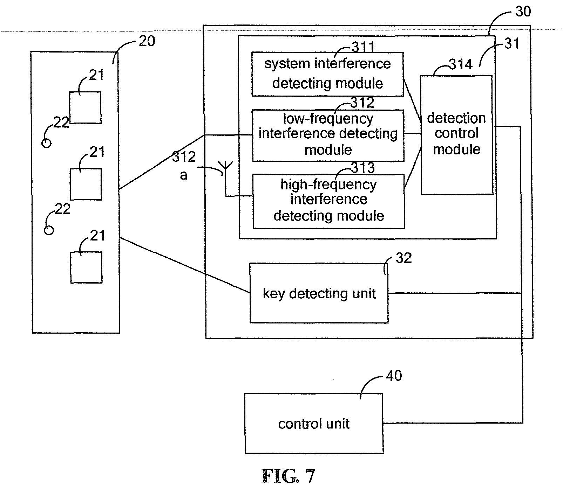

FIG. 7 schematically illustrates a detailed structure of FIG. 6. Referring to FIG. 7, the environment detecting unit 31 may include: a system interference detecting module 311 configured to detect system noise signals with requencies within the frequency range of a power supply; a low-frequency interference detecting module 312 configured to detect low-frequency noise signals with frequencies between a third frequency and a fourth frequency, where the third frequency is less than the first frequency and the fourth frequency is greater than the second frequency, and generate a trigger signal after a signal with a frequency between the first frequency and the second frequency is detected; a high-frequency interference detecting module 313 configured to detect high-frequency noise signals with frequencies between a fifth frequency and a sixth frequency, where the fifth frequency is greater than the fourth frequency; and a detection control module 314 configured to control the system interference detecting module 311, the low-frequency interference detecting module 312 and the high-frequency interference detecting module 313 to operate successively and repeatedly.

The system interference detecting module 311 is mainly configured to detect noises caused by a power supply and other noises with frequencies within the frequency range of the power supply. In some embodiments, the power supply is formed after a voltage transformation of a lighting source and a frequency range of the corresponding system noise signals to be detected is from 50Hz to 75Hz. Generally, these system noise signals may be detected through power ripple detection circuit and method.

The low-frequency interference detecting module 312 is mainly configured to detect low-frequency noise signals with frequencies between the third frequency and the fourth frequency. In some embodiments, the range may be from 20KHz to 500KHz. In order to receive signals with frequencies within the range, the detection plate 20 is configured to be an antenna of the low-frequency interference detecting module 312. One or more balance points made of metal may be set on the detection plate 20 to adjust its capacitive reactance and inductive reactance. Due to the above adjustment and additional adjustment of shape and size of the detection plate 20, both the frequency response and receiving range for signals of the detection plate 20 can include the range from the third frequency to the fourth frequency, namely, the detection plate 20 can receive the signals with frequencies between 20KHz and 500KHz. In some embodiments, capacitive reactance of the detection plate 20 may be 0.5pF, and inductive reactance may be 0.1mH to 0.8mH. The keys 21 and the whole detection plate 20 may be taken as the antenna of the low-frequency interference detecting module 312 and no special low-frequency antenna needs to be configured, thereby improving integration of the system and reducing size of a final product.

The high-frequency interference detecting module 313 is configured to detect high-frequency noise signals with frequencies between the fifth frequency and the sixth frequency. Specifically, the range may be from 900MHz to 3GHz. The high-frequency noise signals are received through an individual antenna 312a.

An anti-interference capacitive touch-key detection system and a detection method therein according to one embodiment of the present disclosure are described in detail in conjunction with FIG. 7.

Initialization may be performed following a power-on event of the anti-interference capacitive touch-key detection system. During the initialization, a detection chip 30 is initialized, namely, the environment detecting unit 31 and the key detecting unit 32 are initialized; furthermore, a control unit 40 is initialized as well. It may take 20ms to complete the whole initialization.

Following the initialization, the environment detecting unit 31 may detect background environment signals, shield signals with frequencies beyond the range from a first frequency to a second frequency and generate a trigger signal after a signal with a frequency between the first frequency and the second frequency is detected. Specifically, the environment detecting unit 31 may generate a trigger signal after a signal with a frequency between 80KHz and 120KHz is detected, and shield signals whose frequencies are other frequencies. It should be known that, a signal with a frequency between 80KHz and 120KHz being detected means that there is a signal between 80KHz and 120KHz whose amplitude is larger than a particular amplitude threshold. The background environment signal detection process is shown in Step S21 in FIG. 3.

The detection process of background environment signals will be described in detail. First, a system interference detecting module 311 may detect system noise signals with frequencies within the frequency range of a power supply. Specifically, frequencies of these system noise signals are between 50Hz and 75Hz. If a signal with a frequency within the range is detected, the key detecting unit 32 may not be triggered to detect a key and the control unit 40 may not determine the key as well. In some embodiments, if amplitude of a system noise signal is less than a first predetermined amplitude (being 100mV here), for example, 50mV, the amplitude of the system noise signal may be transmitted to the control unit 40 and added to a reference signal by the control unit 40. In a subsequent determination process of effective key signals, the amplitude of the system noise signal is removed from a key signal, thereby avoiding the influence to determination caused by power ripple interference. If amplitude of a system noise signal is greater than a second predetermined amplitude (being 500mV here), for example, 800mV, the amplitude of the system noise signal may be transmitted into the control unit 40 and limited therein, namely, in the subsequent determination process of effective key signals, a key signal whose amplitude is greater than the second predetermined amplitude may be determined to be caused by system noises but not a press on a key.

Following the system noise signal detection, the detection control module 314 may control the low-frequency interference detecting module 312 to detect low-frequency noise signals with frequencies between the third frequency and the fourth frequency. Specifically, frequencies of these low-frequency noise signals are between 20KHz and 500KHz and the low-frequency noise signals are received through the detection plate 20. The detailed detection is performed at hopping frequencies. Detecting at hopping frequencies includes receiving external signals whose frequencies are equal to hopping frequency points, where the hopping frequency increases from the third frequency (20KHz) to the fourth frequency (500KHz) and then decreases from the fourth frequency (500KHz) to the third frequency (20KHz), and the frequency points in the increasing process are different from those in the decreasing process. The hopping frequency increases or decreases in 2 units of frequency, namely, the hopping frequency increases or decreases by equal difference.

Low-frequency noise signals with frequencies beyond the range from 80KHz to 120KHz may be shielded, namely, neither the key detecting unit 32 nor the control unit 40 is triggered, thereby avoiding false determination on a key press event caused by low-frequency noise signals.

Following the low-frequency noise signal detection, the detection control module 314 may control the high-frequency interference detecting module 313 to detect high-frequency noise signals with frequencies between the fifth frequency (900MHz) and the sixth frequency (3GHz). High-frequency noise signals with frequencies between 900MHz and 3GHz may be shielded, namely, neither the key detecting unit 32 nor the control unit 40 is triggered, thereby avoiding false determination on a key press event caused by high-frequency noise signals.

Following the high-frequency noise signal detection, the detection control module 314 may control the system interference detecting module 311, the low-frequency interference detecting module 312 and the high-frequency interference detecting module 313 to operate successively and repeatedly. Namely, system noise signals, low-frequency noise signals and high-frequency noise signals are detected repeatedly.

If a signal with a frequency between the first frequency (80KHz) and the second frequency (120KHz) is detected at the low-frequency interference detecting module 312, a trigger signal may be generated to trigger the key detecting unit 32 and the control unit 40 to operate. The key detecting unit 32 is configured to detect the capacitive touch-key to obtain a key signal. The control unit 40 is configured to sample the key signal and output a control signal when the sampling times for an effective key signal in a first time window (3ms) reach or exceed a predetermined value.

In some embodiments, a sampling frequency may vary between the first frequency and the second frequency in turn. The sampling is performed in 1 unit of frequency increasingly or decreasingly, namely, the sampling frequency increases or decreases in an equal difference. Specifically, the sampling frequency increases from the first frequency to the second frequency in 1 unit of frequency and the sampling may stay in each frequency point for a predetermined time, namely, the sampling frequency increases in 1 unit of frequency every predetermined time; then the sampling frequency decreases from the second frequency to the first frequency in 1 unit of frequency and the sampling may stay in each frequency point for the predetermined time, namely, the sampling frequency decreases in 1 unit of frequency every predetermined time; furthermore, the sampling frequency increases from the first frequency to the second frequency and decreases from the second frequency to the first frequency, and the increasing sampling and the decreasing sampling is repeated.

It should be noted that, during the process of sampling a key signal at the control unit 40, background environment signals are still detected continually at the environment detecting unit 31.

If the sampling times for an effective key signal in a first time window are less than a predetermined value, namely, no key press event being detected in the first time window and no control signal being output, the environment detecting unit 31 may enter a sleep state and stop detecting background environment signals.

If the sampling times for an effective key signal in a first time window reach or exceed a predetermined value, namely, a key press event being detected in the first time window and a corresponding control signal being output, then a second time window is opened, where duration of the second time window is longer than that of the first time window. In some embodiments, duration of the second time window may be 3s. The key signal may be continually sampled in the second time window and a control signal may be output when the sampling times for an effective key signal in any first time window of the second time window reach or exceed the predetermined value. Namely, the key signal is detected still by taking the first time window as basis unit in the second time window. A control signal may be output again when the sampling times for an effective key signal in any first time window of the second time window reach or exceed the predetermined value (80 times). If the sampling times for an effective key signal in a second time window are less than a predetermined value, no key press event being detected in the second time window, the environment detecting unit 31 may enter a sleep state and stop detecting background environment signals, thereby reducing power consumption of the whole system. In practice, key press events always occur successively, such as volume is adjusted or channel is switched by pressing a key successively. Therefore, after a key press event is determined in the first time window, the longer second time window is opened to catch other following key press events, thereby effectively improving accuracy of successive key press event detection.

In some embodiments, a watchdog module may be included in the anti-interference capacitive touch-key detection system, configured to wake up the environment detecting unit 31 to detect system noise signals, low-frequency noise signals and high-frequency noise signals if the environment detecting unit 31 has been in a sleep state for a predetermined sleep time(being 128ms here). Generally, duration of a key press event is much longer than 128ms, therefore the environment detecting unit 31 will not miss a key press event when it is in a sleep state, thereby reducing power consumption and ensuring accuracy of detection.

In some embodiments, the control unit 40 may receive background environment signals from the environment detecting unit 31. Considering system noise signals, low-frequency noise signals and high-frequency noise signals being successively scanned one time at the environment detecting unit 31 as a cycle, during a predetermined monitoring time, if a signal in one frequency point exists in 500 cycles (corresponding time of 500 cycles being the predetermined monitoring time), compensation is performed on the threshold of charge change amount according to the amplitude of the signal in the frequency point. For example, a metal component is placed around the capacitive touch-keys 21 for a long time, causing interference with a fixed frequency of 30KHz. Therefore, interference signals exists in the frequency point of 30KHz during background environment signal detection process of 500 cycles and the control unit 40 may perform compensation on the threshold of charge change amount according to the amplitude of the signal in the frequency point of 30KHz. For example, if charge in capacitive touch-keys in a balance state is reduced because of the external interference of 30KHz, the threshold of charge change amount may be adjusted when detecting the capacitive touch-keys, and the adjusted threshold may adapt to the charge in a balance state. Based on the above adjustment, the anti-interference capacitive touch-key detection system may be self-adapting to environment. And the threshold of charge change amount is modified to an original value when the fixed frequency interference disappears, thereby implementing memory and recovery function of environment and ensuring accuracy of detection.

In conclusion, in the present disclosure, a key signal is sampled with varying frequencies and its effectiveness is determined. Compared with a fixed sampling frequency in the existing methods, varying sampling frequencies are difficult to be tracked by varied external signals, thereby reducing the probability of sampled signals being interfered by external signals.

Furthermore, a key detection process may be initiated after an external signal with a frequency within a predetermined frequency range is received. Besides, external signals are received at hopping frequencies, which means that external signals with one kind of frequency point are received in a particular time span. Embodiments of the present disclosure combine receiving signals at hopping frequencies with sampling signals at varying frequencies, which further decreases the coincidence between sampling frequency signals and external signals' frequency, and thereby decreases interferences in key detection.

Further, external signals are received in a predetermined frequency range (from a first frequency to a second frequency) in forward hopping frequency, backward hopping frequency, and so the cycle to repeat, hopping frequency points in the forward process are different from those in the backward process, and staying time at each frequency point lasts for a predetermined time, which improve detection rate, and almost will not miss a key press event.

Although the present disclosure has been disclosed as above with reference to preferred embodiments thereof but will not be limited thereto. Those skilled in the art can modify and vary the embodiments without departing from the scope of the present disclosure. Accordingly, without departing from the scope of the present invented technology scheme, whatever simple modification belong to the protection range of the present invented technology scheme as falling within the scope of the appended claims.

## Claims

1. A key detection method, comprising:
detecting a charge change amount of a capacitance in a capacitive key (21), and
obtaining a key signal, where the key signal is a digital signal corresponding to the charge change amount of the capacitance in the capacitive key (21)
sampling the key signal; and
outputting a control signal,
**characterized in that** the key signal is sampled with varying frequencies, and
that the control signal is outputted if the number of effective key signals sampled in a predetermined time span reaches or exceeds a predetermined value, wherein if a charge change amount of the capacitance corresponding to the sampled key signal is greater than a threshold of charge change amount, the sampled key signal is determined as an effective key signal,
where the sampling frequency varies from a first frequency increasing to a second frequency and then from the second frequency decreasing to the first frequency, the increasing and decreasing sampling processes are repeated, and the sampling stays in each frequency point for a predetermined time.

2. The key detection method according to claim 1, comprising:
receiving external signals; and
when the frequency of an external signal is between the first frequency and the second frequency, generating a trigger signal which is used to trigger the key detection process.

3. The key detection method according to claim 2, where receiving external signals comprises: receiving external signals at hopping frequencies, where receiving at hopping frequencies includes receiving external signals whose frequencies are equal to hopping frequency points;
where the hopping frequency increases from a third frequency to a fourth frequency, then decreases from the fourth frequency to the third frequency, and so the cycle to repeat, the frequency points in the increasing process are different from those in the decreasing process, and the third frequency is less than the first frequency and the fourth frequency is greater than the second frequency.

4. The key detection method according to claim 3, where the frequency range from the third frequency to the fourth frequency comprises three continuous frequency bands, namely, a first frequency band, a second frequency band and a third frequency band, the second frequency band comprises a frequency band from the first frequency to the second frequency and time stayed in each frequency point within the first frequency band or the third frequency band is less than that in each frequency point within the second frequency band.

5. The key detection method according to claim 3, where the third frequency is 20KHz and the fourth frequency is 500KHz, the frequency range from the third frequency to the fourth frequency comprises three continuous frequency bands, namely, a first frequency band, a second frequency band and a third frequency band, the first frequency band is from 20KHz to 80KHz, the second frequency band is from 80KHz to 300KHz, and the third frequency band is from 300KHz to 500KHz; and
time stayed in each frequency point within the first frequency band or in the third frequency band is 0.1ms and time stayed in each frequency point within the second frequency band is 0.2ms.

6. The key detection method according to claim 3,
where the third frequency is 20KHz and the fourth frequency is 500KHz, and the hopping frequency increasing from the third frequency to the fourth frequency comprises: the hopping frequency increasing from 20KHz to 21KHz, then increasing from 21KHz to 499KHz in 2KHz and increasing from 499KHz to 500KHz; and
the hopping frequency decreasing from the fourth frequency to the third frequency comprises: the hopping frequency decreasing from 500KHz to 20KHz in 2KHz.

7. A key detection apparatus, comprising:
a key detecting unit (41) configured to detect a charge change amount of a capacitance in a capacitive key (21), and obtaining a key signal, where the key signal is a digital signal corresponding to the charge change amount of the capacitance in the capacitive key (21); and
an effective signal detecting unit (42),
**characterized in that** the effective signal detecting unit (42) is configured to sample the key signal with varying frequencies and output a control signal if the number of effective key signals sampled in a predetermined time span reaches or exceeds a predetermined value, wherein if a charge change amount of the capacitance corresponding to the sampled key signal is greater than a threshold of charge change amount, the sampled key signal is determined as an effective key signal,
where the sampling frequency varies from a first frequency increasing to a second frequency, then from the second frequency decreasing to the first frequency, the increasing and decreasing sampling processes are repeated, and the sampling stays in each frequency point for a predetermined time.

8. The key detection apparatus according to claim 7, further comprising:
a receiving unit (51) configured to receive external signals; and
an external signal detecting unit (52) configured to generate a trigger signal which is used to trigger the key detection process when the frequency of an external signal is between the first frequency and the second frequency;
where the key detecting unit (51) detects a key (21) to obtain a key signal after receiving the trigger signal.

9. The key detection apparatus according to claim 8, where the receiving unit (51) comprises:
an antenna (511) configured to receive external environment signals; and
a frequency hopping receiving unit (512) configured to receive external signals at hopping frequencies, receiving at hopping frequencies includes receiving external signals whose frequencies are equal to hopping frequency points;
where the hopping frequency increases from a third frequency to a fourth frequency, then decreases from the fourth frequency to the third frequency, and so the cycle to repeat, the frequency points in the increasing process are different from those in the decreasing process, and the third frequency is less than the first frequency and the fourth frequency is greater than the second frequency.

10. The key detection apparatus according to claim 9, where the frequency range from the third frequency to the fourth frequency comprises three continuous frequency bands, namely, a first frequency band, a second frequency band and a third frequency band, the second frequency band comprises a frequency band from the first frequency to the second frequency, and time stayed in each frequency point within the first frequency band or the third frequency band is less than that in each frequency point within the second frequency band.

11. The key detection apparatus according to claim 9, where the third frequency is 20KHz and the fourth frequency is 500KHz, the frequency range from the third frequency to the fourth frequency comprises three continuous frequency bands, namely, a first frequency band, a second frequency band and a third frequency band, the first frequency band is from 20KHz to 80KHz, the second frequency band is from 80KHz to 300KHz, and the third frequency band is from 300KHz to 500KHz; and
time stayed in each frequency point within the first frequency band or in the third frequency band is 0.1ms and time stayed in each frequency point within the second frequency band is 0.2ms.

## Patentansprüche

1. Tasten-Erkennung-Verfahren, umfassend:
Erfassen einer Ladungsänderungsmenge einer Kapazität in eine kapazitive Taste (21) und Erhalten eines Tastensignals, wobei das Tastensignal ein digitales Signal ist, welches der Ladungsänderungsmenge der Kapazität in der kapazitiven Taste (21) entspricht
Abtasten des Tastensignals; und
Ausgeben eines Steuersignals,
**dadurch gekennzeichnet, dass** das Tastensignal mit unterschiedlichen Frequenzen abgetastet wird, und
dass das Steuersignal ausgegeben wird, wenn die Anzahl der in einer vorbestimmten Zeitspanne abgetasteten Effektiv-Tastensignale einen vorbestimmten Wert erreicht oder überschreitet, wobei, wenn eine Ladungsänderungsmenge der dem abgetasteten Tastensignal entsprechenden Kapazität größer als ein Schwellenwert für die Ladungsänderungsmenge ist, das abgetastete Tastensignal als Effektiv-Tastensignal bestimmt wird,
wobei die Abtastfrequenz sich von einer ersten Frequenz auf eine zweite Frequenz zunehmend und dann von der zweiten Frequenz auf die erste Frequenz abnehmend ändert, wobei die zunehmenden und abnehmenden Abtastprozesse wiederholt werden, und die Abtastung in jedem Frequenzpunkt für eine vorbestimmte Zeit verbleibt.

2. Tasten-Erkennung-Verfahren nach Anspruch 1, umfassend:
Empfangen externer Signale; und
wenn die Frequenz eines externen Signals zwischen der ersten Frequenz und der zweiten Frequenz liegt, Erzeugen eines Trigger-Signals, das zum Auslösen des Tasten-Erkennung-Verfahrens verwendet wird.

3. Tasten-Erkennung-Verfahren nach Anspruch 2, wobei das Empfangen externer Signale umfasst:
Empfangen externer Signale mit Sprungfrequenzen, wobei das Empfangen mit Sprungfrequenzen das Empfangen externer Signale beinhaltet, deren Frequenzen gleich Sprungfrequenzpunkten sind;
wobei die Sprungfrequenz von einer dritten Frequenz zu einer vierten Frequenz zunimmt, dann von der vierten Frequenz zu der dritten Frequenz abnimmt, und so den Zyklus zu wiederholen, wobei die Frequenzpunkte im zunehmenden Prozess von denen im abnehmenden Prozess verschieden sind, und wobei die dritte Frequenz kleiner als die erste Frequenz ist und die vierte Frequenz größer als die zweite Frequenz ist.

4. Tasten-Erkennung-Verfahren nach Anspruch 3, wobei der Frequenzbereich von der dritten Frequenz bis zur vierten Frequenz drei kontinuierliche Frequenzbänder umfasst, nämlich ein erstes Frequenzband, ein zweites Frequenzband und ein drittes Frequenzband, wobei das zweite Frequenzband ein Frequenzband von der ersten Frequenz bis zur zweiten Frequenz umfasst und die Zeit für die in jedem Frequenzpunkt verblieben wird innerhalb des ersten Frequenzbandes oder des dritten Frequenzbandes kleiner ist als die in jedem Frequenzpunkt innerhalb des zweiten Frequenzbandes.

5. Tasten-Erkennung-Verfahren nach Anspruch 3, wobei die dritte Frequenz 20 kHz und die vierte Frequenz 500 kHz beträgt, der Frequenzbereich von der dritten Frequenz bis zur vierten Frequenz drei kontinuierliche Frequenzbänder umfasst, nämlich ein erstes Frequenzband, ein zweites Frequenzband und ein drittes Frequenzband, wobei das erste Frequenzband von 20 kHz bis 80 kHz, das zweite Frequenzband von 80 kHz bis 300 kHz und das dritte Frequenzband von 300 kHz bis 500 kHz ist; und
die Zeit, für welche in jedem Frequenzpunkt innerhalb des ersten Frequenzbandes oder in dem dritten Frequenzband verblieben wird, 0,1 ms beträgt und die Zeit, für welche in jedem Frequenzpunkt innerhalb des zweiten Frequenzbandes verblieben wird, 0,2 ms beträgt.

6. Tasten-Erkennung-Verfahren nach Anspruch 3,
wobei die dritte Frequenz 20 kHz und die vierte Frequenz 500 kHz beträgt und die Sprungfrequenz von der dritten Frequenz zur vierten Frequenz ansteigt, umfassend: die Sprungfrequenz steigt von 20 kHz auf 21 kHz, dann steigt sie von 21 kHz auf 499 kHz in 2 kHz und steigt von 499 kHz auf 500 kHz; und
die Sprungfrequenz, die von der vierten Frequenz zur dritten Frequenz abnimmt, umfassend: die Sprungfrequenz, die von 500KHz auf 20KHz in 2KHz abnimmt.

7. Tasten-Erkennung-Vorrichtung, umfassend:
eine Tasten-Erkennung-Einheit (41), die konfiguriert ist, um eine Ladungsänderungsmenge einer Kapazität in einer kapazitiven Taste (21) zu erfassen und ein Tastensignal zu erhalten, wobei das Tastensignal ein digitales Signal ist, das der Ladungsänderungsmenge der Kapazität in der kapazitiven Taste (21) entspricht; und
eine Effektiv-Signal-Erkennung-Einheit (42),
**dadurch gekennzeichnet, dass** die Effektiv-Signal-Erkennung-Einheit (42) konfiguriert ist, um das Tastensignal mit variierenden Frequenzen abzutasten und ein Steuersignal auszugeben, wenn die Anzahl der Effektiv-Tastensignale, die in einer vorbestimmten Zeitspanne abgetastet werden, einen vorbestimmten Wert erreicht oder überschreitet, wobei, wenn eine Ladungsänderungsmenge der Kapazität, die dem abgetasteten Tastensignal entspricht, größer als ein Schwellenwert der Ladungsänderungsmenge ist, das abgetastete Tastensignal als ein Effektiv-Tastensignal bestimmt wird,
wobei die Abtastfrequenz sich von einer ersten Frequenz, die auf eine zweite Frequenz zunehmend und dann von der zweiten Frequenz, die auf die erste Frequenz abnehmend ändert, wobei die zunehmenden und abnehmenden Abtastprozesse wiederholt werden, und die Abtastung in jedem Frequenzpunkt für eine vorbestimmte Zeit verbleibt.

8. Tasten-Erkennung-Vorrichtung nach Anspruch 7, ferner umfassend:
eine Empfangseinheit (51), die konfiguriert ist, um externe Signale zu empfangen; und
eine Extern-Signal-Erkennung-Einheit (52), die konfiguriert ist, um ein Trigger-Signal zu erzeugen, das verwendet wird, um den Tasten-Erkennung-Verfahren auszulösen, wenn die Frequenz eines externen Signals zwischen der ersten Frequenz und der zweiten Frequenz liegt;
wobei die Tasten-Erkennung-Einheit (51) eine Taste (21) erfasst, um ein Tastensignal nach dem Empfangen des Trigger-Signals zu erhalten.

9. Tasten-Erkennung-Vorrichtung nach Anspruch 8, wobei die Empfangseinheit (51) umfasst:
eine Antenne (511), die konfiguriert ist, um externe Umgebungssignale zu empfangen; und
eine Frequenzsprung-Empfangseinheit (512), die konfiguriert ist, um externe Signale mit Sprungfrequenzen zu empfangen, wobei das Empfangen mit Sprungfrequenzen das Empfangen externer Signale beinhaltet, deren Frequenzen gleich den Sprungfrequenzpunkten sind;
wobei die Sprungfrequenz von einer dritten Frequenz zu einer vierten Frequenz zunimmt, dann von der vierten Frequenz zu der dritten Frequenz abnimmt, und so den Zyklus zu wiederholen, wobei die Frequenzpunkte im zunehmenden Prozess von denen im abnehmenden Prozess verschieden sind, und die dritte Frequenz kleiner als die erste Frequenz ist und die vierte Frequenz größer als die zweite Frequenz ist.

10. Tasten-Erkennung-Vorrichtung nach Anspruch 9, wobei der Frequenzbereich von der dritten Frequenz bis zur vierten Frequenz drei kontinuierliche Frequenzbänder umfasst, nämlich ein erstes Frequenzband, ein zweites Frequenzband und ein drittes Frequenzband, wobei das zweite Frequenzband ein Frequenzband von der ersten Frequenz bis zur zweiten Frequenz umfasst und die Zeit für die in jedem Frequenzpunkt verblieben wird innerhalb des ersten Frequenzbandes oder des dritten Frequenzbandes kleiner ist als die in jedem Frequenzpunkt innerhalb des zweiten Frequenzbandes.

11. Tasten-Erkennung-Vorrichtung nach Anspruch 9, wobei die dritte Frequenz 20 kHz und die vierte Frequenz 500 kHz beträgt, der Frequenzbereich von der dritten Frequenz bis zur vierten Frequenz drei kontinuierliche Frequenzbänder umfasst, nämlich ein erstes Frequenzband, ein zweites Frequenzband und ein drittes Frequenzband, das erste Frequenzband von 20 kHz bis 80 kHz, das zweite Frequenzband von 80 kHz bis 300 kHz und das dritte Frequenzband von 300 kHz bis 500 kHz ist; und
die Zeit, für welche in jedem Frequenzpunkt innerhalb des ersten Frequenzbandes oder in dem dritten Frequenzband verblieben wird, 0,1 ms beträgt und die Zeit, für welche in jedem Frequenzpunkt innerhalb des zweiten Frequenzbandes verblieben wird, 0,2ms beträgt.

## Revendications

1. Procédé de détection d'une clé, comprenant
détecter une quantité de variation de charge d'une capacité dans une clé capacitive (21), et obtenir un signal de clé, où le signal de clé est un signal numérique correspondant à la quantité de variation de charge de la capacité dans la clé capacitive (21),
l'échantillonnage du signal clé ; et
la sortie d'un signal de commande,
**caractérisé en ce que** le signal de clé est échantillonné avec des fréquences variables, et
**en ce que** le signal de commande est émis si le nombre de signaux de clé effectifs échantillonnés dans un intervalle de temps prédéterminé atteint ou dépasse une valeur prédéterminée, dans lequel, si une quantité de variation de charge de la capacité correspondant au signal de clé échantillonné est supérieure à une quantité de variation de charge seuil, le signal de clé échantillonné est déterminé comme un signal de clé effectif,
où la fréquence d'échantillonnage varie d'une première fréquence augmentant à une deuxième fréquence et ensuite de la deuxième fréquence diminuant à la première fréquence, les processus d'échantillonnage croissant et décroissant sont répétés, et l'échantillonnage passe dans chaque point de fréquence pendant un temps prédéterminé.

2. Procédé de détection de clé selon la revendication 1, comprenant :
la réception de signaux externes ; et
lorsque la fréquence d'un signal externe se situe entre la première fréquence et la deuxième fréquence, générer un signal de déclenchement qui est utilisé pour déclencher le processus de détection de clé.

3. Procédé de détection de clé selon la revendication 2, dans lequel la réception de signaux externes comprend : la réception de signaux externes à des fréquences de saut, dans lequel la réception à des fréquences de saut comprend la réception de signaux externes dont les fréquences sont égales aux points de fréquence de saut ;
où la fréquence de saut augmente d'une troisième fréquence à une quatrième fréquence, puis diminue de la quatrième fréquence à la troisième fréquence, et donc le cycle de répétition, les points de fréquence dans le processus croissant sont différents de ceux dans le processus décroissant, et la troisième fréquence est inférieure à la première fréquence et la quatrième fréquence est supérieure à la deuxième fréquence.

4. Procédé de détection de clé selon la revendication 3, dans lequel la gamme de fréquences allant de la troisième à la quatrième fréquence comprend trois bandes de fréquences continues, à savoir une première bande de fréquences, une deuxième bande de fréquences et une troisième bande de fréquences, où la deuxième bande de fréquences comprend une bande de fréquences allant de la première fréquence à la deuxième fréquence et le temps passé dans chaque point de fréquence dans la première bande de fréquences ou la troisième bande de fréquences est inférieur à celui passé dans chaque point de fréquence dans la deuxième bande de fréquences.

5. La méthode de détection de clé selon la revendication 3, où la troisième fréquence est de 20KHz et la quatrième fréquence est de 500KHz, la gamme de fréquences allant de la troisième fréquence à la quatrième fréquence comprend trois bandes de fréquences continues, à savoir une première bande de fréquences, une deuxième bande de fréquences et une troisième bande de fréquences, la première bande de fréquences est de 20KHz à 80KHz, la deuxième bande de fréquences est de 80KHz à 300KHz, la troisième bande de fréquences étant de 300KHz à 500KHz ; et
le temps passé dans chaque point de fréquence dans la première bande de fréquences ou dans la troisième bande de fréquences est de 0,1ms et le temps passé dans chaque point de fréquence dans la deuxième bande de fréquences est de 0,2ms.

6. La méthode de détection de clé selon la revendication 3,
où la troisième fréquence est 20KHz et la quatrième fréquence est 500KHz, et la fréquence de saut augmentant de la troisième fréquence à la quatrième fréquence comprend : la fréquence de saut augmentant de 20KHz à 21KHz, puis augmentant de 21KHz à 499KHz en 2KHz et augmentant de 499KHz à 500KHz ; et
la fréquence de saut décroissant de la quatrième fréquence à la troisième fréquence comprend : la fréquence de saut décroissant de 500KHz à 20KHz en 2KHz.

7. Appareil de détection de clé, comprenant :
une unité de détection de clé (41) configurée pour détecter une quantité de variation de charge d'une capacité dans une clé capacitive (21), et obtenir un signal de clé, où le signal de clé est un signal numérique correspondant à la quantité de variation de charge de la capacité dans la clé capacitive (21) ;
et
une unité de détection de signal efficace (42),
**caractérisé en ce que** l'unité de détection de signal efficace (42) est configurée pour échantillonner le signal de clé avec des fréquences variables et pour délivrer un signal de commande si le nombre de signaux de clé efficaces échantillonnés dans un intervalle de temps prédéterminé atteint ou dépasse une valeur prédéterminée, dans lequel si une quantité de variation de charge de la capacité correspondant au signal de clé échantillonné est supérieure à une quantité seuil de variation de charge, le signal de clé échantillonné est déterminé comme un signal clé efficace,
où la fréquence d'échantillonnage varie d'une première fréquence augmentant à une deuxième fréquence, puis de la deuxième fréquence diminuant à la première fréquence, les processus d'échantillonnage croissant et décroissant sont répétés et l'échantillonnage passe dans chaque point de fréquence pendant un temps prédéterminé.

8. Appareil de détection de clé selon la revendication 7, comprenant en outre :
une unité de réception (51) configurée pour recevoir des signaux externes ; et
une unité de détection de signal externe (52) configurée pour générer un signal de déclenchement qui est utilisé pour déclencher le processus de détection de clé lorsque la fréquence d'un signal externe se situe entre la première fréquence et la deuxième fréquence ;
où l'unité de détection de clé (51) détecte une clé (21) pour obtenir un signal de clé après réception du signal de déclenchement.

9. Appareil de détection de clé selon la revendication 8, dans lequel l'unité de réception (51) comprend :
une antenne (511) configurée pour recevoir des signaux d'environnement externe ; et
une unité de réception à saut de fréquence (512) configurée pour recevoir des signaux externes à des fréquences de saut, la réception à des fréquences de saut comprend la réception de signaux externes dont les fréquences sont égales aux points de fréquence de saut ;
où la fréquence de saut augmente d'une troisième fréquence à une quatrième fréquence, puis diminue de la quatrième fréquence à la troisième fréquence, et donc le cycle de répétition, les points de fréquence dans le processus croissant sont différents de ceux dans le processus décroissant, et la troisième fréquence est inférieure à la première fréquence et la quatrième fréquence est supérieure à la deuxième fréquence.

10. Dispositif de détection de clé selon la revendication 9, dans lequel la gamme de fréquences allant de la troisième à la quatrième fréquence comprend trois bandes de fréquences continues, à savoir une première bande de fréquences, une deuxième bande de fréquences et une troisième bande de fréquences, où la deuxième bande de fréquences comprend une bande de fréquences allant de la première à la deuxième fréquence et le temps passé dans chaque point de fréquence dans la première bande de fréquences ou la troisième bande de fréquences est inférieur à celui passé dans chaque point de fréquence dans la deuxième bande de fréquences.

11. L'appareil de détection de clé selon la revendication 9, où la troisième fréquence est 20KHz et la quatrième fréquence est 500KHz, où la gamme de fréquences de la troisième fréquence à la quatrième fréquence comprend trois bandes de fréquences continues, à savoir une première bande de fréquences, une deuxième bande de fréquences et une troisième bande de fréquences, où la première bande de fréquences est de 20KHz à 80KHz, la deuxième bande de fréquences est de 80KHz à 300KHz et la troisième bande de fréquences est de 300KHz à 500KHz ; et
le temps passé en chaque point de fréquence dans la première bande de fréquences ou dans la troisième bande de fréquences est de 0,1ms et le temps passé dans chaque point de fréquence dans la deuxième bande de fréquences est de 0,2ms.
